(19) Europäisches Patentamt / European Patent Office / Office européen des brevets

(11) **EP 3 549 260 B1**

(12) **FASCICULE DE BREVET EUROPEEN**

(45) Date de publication et mention de la délivrance du brevet:
**04.08.2021 Bulletin 2021/31**

(21) Numéro de dépôt: **17811518.4**

(22) Date de dépôt: **28.11.2017**

(51) Int Cl.:
*H03H 7/01* *(2006.01)*        *H01P 1/203* *(2006.01)*
*H01P 7/08* *(2006.01)*

(86) Numéro de dépôt international:
**PCT/EP2017/080711**

(87) Numéro de publication internationale:
**WO 2018/099924 (07.06.2018 Gazette 2018/23)**

(54) **FILTRE ACCORDABLE A INDUCTANCE VARIABLE**

ABSTIMMBARES FILTER MIT VARIABLER INDUKTANZ

TUNABLE FILTER WITH VARIABLE INDUCTANCE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **29.11.2016 FR 1601686**

(43) Date de publication de la demande:
**09.10.2019 Bulletin 2019/41**

(73) Titulaire: **THALES**
**92400 Courbevoie (FR)**

(72) Inventeurs:
• **GUERN, Pierre**
 **49309 Cholet (FR)**
• **FOUGERAY, Germain**
 **49309 Cholet (FR)**
• **SABOUREAU, Cédrick**
 **49309 Cholet (FR)**

(74) Mandataire: **Marks & Clerk France**
**Immeuble "Visium"**
**22, avenue Aristide Briand**
**94117 Arcueil Cedex (FR)**

(56) Documents cités:
**JP-A- S6 033 724          JP-A- 2006 005 798**
**US-A1- 2004 036 551      US-A1- 2006 087 388**

• **ZHAO ZHI-YUAN ET AL: "High-power VHF tunable filters with high selectivity", ELECTRONICS LET, IEE, vol. 50, no. 19, 11 septembre 2014 (2014-09-11), pages 1356-1358, XP006049450,**

EP 3 549 260 B1

**Description**

L'invention concerne un filtre accordable à inductance variable. Elle est par exemple utilisée pour des émetteurs/récepteurs radios. Elle concerne aussi des filtres de puissance, très haute fréquence ou Very High Frequency, VHF, et ultra haute fréquence ou en anglo-saxon Ultra High Frequency, UHF.

Le fonctionnement en cosite des émetteurs/récepteurs radios génère une dégradation dans le fonctionnement des postes radios, lorsqu'ils sont en situation de proximité entre un émetteur et un récepteur d'un autre réseau ceci, en raison du bruit hors bande émis par l'émetteur et/ou de la désensibilisation d'un récepteur par des émetteurs proches. Dans le domaine UHF et une partie de la bande VHF, on recherche une canalisation de largeur de bande fixe et donc des filtres cosite de largeur de bande passante et de réjection constantes avec la fréquence d'accord. Or, les filtres accordables sont « naturellement » à facteur de qualité $Q_{filtre}$ constant. Cela signifie que le filtre s'élargit proportionnellement avec la fréquence d'accord.

La topologie des filtres accordables fait appel à des éléments résonnants constitués d'inductances ou de lignes de transmission (barreaux) fixes. L'accord est réalisé au moyen de capacités variables mises en parallèle à une extrémité de l'inductance ou du barreau résonnant. Le problème est que le facteur de qualité ou la surtension du filtre est de la forme :

$$Qfiltre \cong Fr\acute{e}quenceCentrale \ / \ BandePassante$$

et d'autre part

$$Qfiltre \cong Imp\acute{e}danceCouplage \ / \ Imp\acute{e}danceInterne$$

(*Impédance Interne du résonateur à la fréquence centrale*). Comme on veut une bande passante constante, on en déduit : $Qfiltre \cong k.Fr\acute{e}quenceCentrale$
*ImpédanceCouplage* $\cong$ *k'.ImpédanceInterne.FréquenceCentrale*

Comme dans la topologie classique des filtres, l'impédance interne du filtre est de la forme $L\omega$ (inductance fixe) ou $Z_o.tan\theta$ ($\cong Z_o.f/f_o$, pour un barreau court), on en déduit :
*ImpédanceCouplage* $\cong$ *k". (FréquenceCentrale)*$^2$.

Ceci est techniquement et physiquement difficile à réaliser, en respectant le critère d'une bonne proportionnalité et donc d'une bonne constance de la bande passante du filtre sur une large plage d'accord de la fréquence centrale.

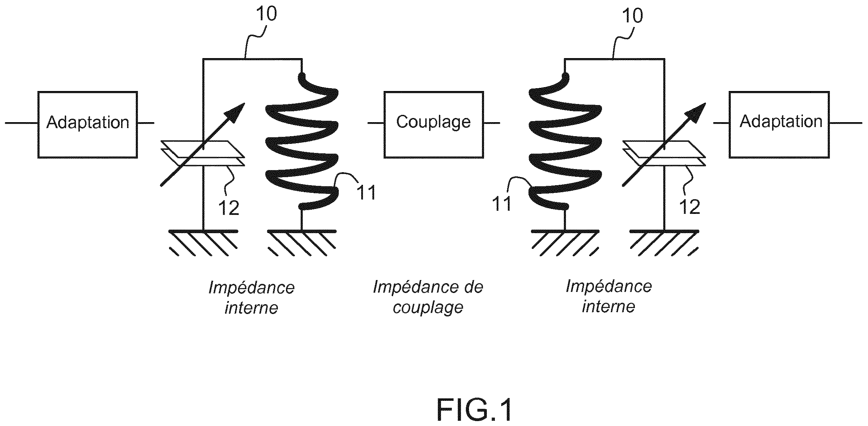

La figure 1 illustre un filtre accordable de forte puissance selon l'art antérieur. Le filtre comporte deux résonateurs 10 constitués de barreaux ou d'inductances fixes 11 accordés par une banque de capacités commutées 12.

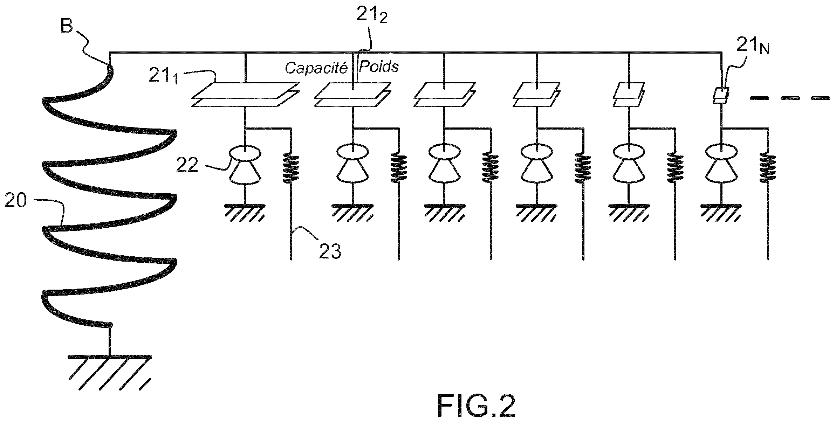

La figure 2 illustre une variante de filtre accordable, comprenant une inductance de valeur fixe (constante) 20 et plusieurs capacités fixes commutées 21i. Les capacités fixes commutées, présentant des valeurs étagées, sont toutes regroupées en bout de barreau ou inductance au point B et commutées par des diodes de type PIN 22 activées par un contrôle de diode 23. La valeur de l'inductance est fixe et l'impédance interne du filtre est proportionnelle à la fréquence d'accord.

La demande de brevet US 2006087388 divulgue un résonateur présentant des moyens pour déterminer une fréquence produisant un effet sur la fréquence de résonance d'une ligne accordée. L'objectif de ce document est de fournir un résonateur de petite taille.

Le document JP S 6033724 décrit un tuner variable dont la structure n'utilise pas de réactance.

La demande de brevet US 2004036551 divulgue une structure caractéristique pour un module fonctionnant en haute fréquence.

Malgré les avantages qu'ils procurent, les filtres selon l'art antérieur ne font qu'approximer la réponse recherchée du filtre du fait de la complexité, voire de l'impossibilité, de synthétiser l'impédance de couplage nécessaire. Certaines topologies de filtre font appel à des impédances accordables pour le couplage au détriment des pertes du filtre.

Il existe donc un besoin de disposer d'un filtre présentant une largeur de bande passante et une bande de réjection constantes avec la fréquence d'accord.

Le procédé selon l'invention consiste, notamment, à maintenir l'impédance interne du filtre constante ou pratiquement constante en fonction de la fréquence d'accord $F_{accord}$ au moyen de capacités commutées fixes, dont les positions sont distribuées le long de l'inductance formant le résonateur et présentant des valeurs variables en fonction de leur position.

L'invention concerne un filtre accordable comportant au moins deux résonateurs accordables, un premier résonateur comprenant au moins une inductance ou ligne de transmission, ladite inductance ou ligne de transmission ayant une première extrémité connectée à la masse M et une deuxième extrémité couplée au deuxième résonateur via une impédance de couplage et plusieurs capacités commutées comportant plusieurs capacités de valeurs variables en fonction de la position caractérisé en ce que :

- Ladite inductance ou ligne de transmission comporte plusieurs points d'accès ou points de connexion distribués le long de ladite inductance permettant de connecter ou non une capacité commutée dont la valeur est définie en fonction de sa position sur l'inductance,
- Les capacités commutées sont réparties le long de l'inductance de la manière suivante : les capacités de poids forts, correspondant aux basses fréquences d'accord, donc à une valeur d'inductance équivalente vue au point élevée, sont disposées plus loin de la masse que les capacités de poids faibles, correspondant aux hautes fréquences qui sont disposées près de la masse vers la première extrémité de l'inductance,
- Les valeurs des capacités et leurs positions sur l'inductance sont définies de façon à ce que l'impédance du résonateur soit maintenue constante dans toute la bande d'accord du filtre accordable, et l'impédance du résonateur

$\sqrt{\dfrac{L_{equi}}{C_{equi}}}$ est maintenue constante à la fréquence de résonance accordable $\dfrac{1}{2\pi\sqrt{\dfrac{1}{L_{equi}*C_{equi}}}}$.

Le nombre N de capacités et la ou les capacités à activer sont, par exemple, fixés en fonction du pas de variation $\delta f$ de fréquence et de la plage de fréquences de fonctionnement $[F_{min}, F_{max}]$ du filtre.

Les capacités sont, par exemple, reliées à des diodes PIN adaptées à réaliser leur commutation.

La position des points d'accès et les valeurs de capacité commutées peuvent être choisies afin d'obtenir pour le filtre une valeur d'impédance interne à la fréquence centrale $F_c$ vue par le filtre à la deuxième extrémité de ladite inductance proche de l'impédance de couplage quasi constante.

La bande de fréquence est la bande VHF ou la bande UHF.

Le filtre selon l'invention est utilisé par exemple dans un émetteur/récepteur radio.

L'invention concerne aussi un procédé mis en œuvre dans un filtre accordable selon l'invention fonctionnant dans une plage de fréquence $[F_{min}, F_{max}]$ avec une fréquence d'accord $F_{accord}$, caractérisé en ce que :

- On définit le nombre N de capacités, leur position en fonction de la plage de fréquence et du pas de fréquence,
- On choisit le nombre de capacités à commuter afin d'obtenir une largeur de bande passante constante et une bande de réjection constante avec la fréquence d'accord.

D'autres caractéristiques et avantages de la présente invention apparaîtront mieux à la lecture de la description d'exemples de réalisation donnés à titre illustratif, annexée des figures qui représentent :

- Figure 1, une première architecture d'un filtre accordable selon l'art antérieur,
- Figure 2, la moitié d'un filtre accordable comprenant une banque de capacités commutées, et
- Figure 3, une illustration d'un filtre selon l'invention.

L'un des objectifs est d'obtenir une impédance constante $\sqrt{\dfrac{L_{equi}}{C_{equi}}}$ à la fréquence de résonance accordable

$\dfrac{1}{2\pi\sqrt{\dfrac{1}{L_{equi}*C_{equi}}}}$. Le problème est le ratio de l'impédance du résonateur par rapport à l'impédance de couplage, ce qui va définir la bande passante du filtre passe bande recherché. Pour cela, les petits poids de capacité correspondant aux fréquences élevées sont associés physiquement à une faible valeur de réactance en étant plus près de l'extrémité à la masse. Les capacités de poids plus forts sont au contraire très éloignées de la masse afin d'être mises en parallèle avec une self importante.

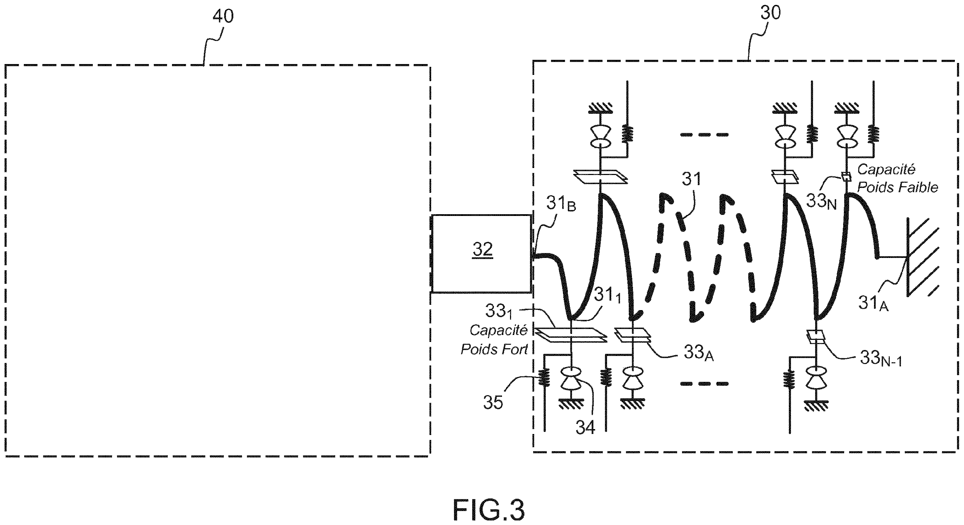

La figure 3 illustre un exemple de filtre selon l'invention dans lequel les capacités sont réparties ou distribuées le long de l'inductance entre une première extrémité de l'inductance reliée à la masse et une deuxième extrémité reliée au reste du filtre.

L'idée mise en œuvre est de faire varier électriquement la valeur de l'inductance équivalente, simultanément avec la commutation des poids capacitifs (capacités de valeurs variables en fonction de la position), afin de conserver une valeur de bande passante sensiblement constante et faire varier la fréquence selon un plan de fréquences $[F_{min},$

$F_{max}$] défini par une application donnée. Le plan de fréquences définit, par exemple, les différentes fréquences à utiliser et le pas de fréquence $\Delta F$ avec lequel on va faire varier les fréquences.

Pour construire l'architecture du filtre selon l'invention, on va donc maintenir l'impédance interne constante en fonction de la fréquence d'accord $F_{accord}$ et pour cela rendre la valeur de l'inductance ou la longueur électrique du barreau variable avec la fréquence dans le sens suivant :

Basses fréquences d'accord - fortes valeurs d'inductance équivalentes,

Hautes fréquences d'accord - faibles valeurs d'inductance équivalentes.

La figure 3 illustre un exemple d'architecture du filtre selon l'invention, sur laquelle seul un demi-élément résonateur du filtre est détaillé pour des raisons de simplification de lecture, le filtre fonctionnant dans une plage de fréquence [$F_{min}$, $F_{max}$]. La partie symétrique du filtre, deuxième résonateur 40 comprend des éléments identiques à ceux décrits pour le résonateur 30 et sera déduite de la description qui va suivre, sans difficulté par l'homme du métier.

Sur la figure 3, le résonateur 30 comporte plusieurs capacités commutées qui sont distribuées le long de l'inductance 31. Une première extrémité $31_A$ de l'inductance est raccordée à la masse M. Une deuxième extrémité $31_B$ est raccordée, à l'aide d'une impédance de couplage 32 comme indiqué figure 1, à un autre résonateur 40 non détaillé pour des raisons de simplification. L'inductance comporte plusieurs points d'accès 31i ou points de connexion répartis sur sa longueur, les points d'accès servant à la connexion des capacités commutées qui vont être mises en connexion en fonction des valeurs souhaitées. Le filtre comprend par exemple N capacités commutées 33i commandées par une diode PIN 34 reliée à une commande d'activation 35.

Une capacité commutée 33i est positionnée en un point 31i de l'inductance. Ce point peut être repéré par sa distance di comptée à partir d'une des extrémités $31_A$, $31_B$ de l'inductance 31. Dans l'exemple, le point de connexion de la capacité est repéré par rapport à la deuxième extrémité $31_B$ de l'inductance.

Les capacités commutées sont réparties le long de l'inductance de la manière suivante : les capacités de poids forts, correspondant aux basses fréquences d'accord, donc à une valeur d'inductance équivalente vue au point $31_B$ élevée, sont disposées plus loin de la masse que les capacités de poids faibles, correspondant aux hautes fréquences qui sont disposées près de la masse vers la première extrémité $31_A$ de l'inductance.

Les valeurs des capacités et leurs positions sur l'inductance sont définies de façon à ce que l'impédance du résonateur soit maintenue constante dans toute la bande d'accord du filtre accordable. L'impédance du résonateur $\sqrt{\dfrac{L_{equi}}{C_{equi}}}$ est maintenue constante à la fréquence de résonance accordable $\dfrac{1}{2\pi\sqrt{\dfrac{1}{L_{equi}*C_{equi}}}}$.

La valeur de l'inductance équivalente $L_{equi}$, va varier électriquement, en jouant sur le nombre de capacités commutées connectées et le choix de leur position le long de l'inductance. L'idée sera de connecter certaines des capacités $C_i$. En faisant varier la valeur de l'inductance et aussi la valeur de la capacité totale du filtre (correspondant à l'ensemble des capacités commutées connectées pour une configuration donnée), il est possible de conserver pour le filtre une impédance constante en fonction de la fréquence d'accord et de ce fait une valeur de bande passante constante pour le filtre.

Le nombre N de capacités commutées est, par exemple, choisi en fonction du pas de fréquence $\delta f$ à explorer dans la bande de fréquence [$F_{min}$, $F_{max}$] pour une application donnée.

Les valeurs et la position des capacités $C_i$ mises en fonction par commutation sont choisies en fonction des valeurs de fréquence désirées dans la bande d'accord du filtre. La banque de capacités est répartie sur toute la longueur de l'inductance donnant par commutation des capacités, l'équivalent d'une inductance variable en fréquence par variation de la longueur électrique

Le positionnement, distance di d'une capacité par rapport à une des extrémités de l'inductance participe à la définition de la valeur de l'inductance L. Par exemple, en activant la capacité $33_1$, on définit une valeur d'inductance $L_1$ égale à la valeur totale de l'inductance - la valeur d'inductance correspondant à $d_1$. Le nombre et le choix des capacités commutées activées en fonction de leur emplacement sur l'inductance sont fonction par exemple de la valeur de fréquence à obtenir et de la résolution souhaitée en fréquence.

En première approximation, on veut une impédance constante, ce qui induit que $\sqrt{\dfrac{Li}{Ci}}$ doit être constant et donc que l'inductance est proportionnelle à la capacité. On aura la Fréquence Centrale $F_c$ du filtre proportionnelle à $\sqrt{\dfrac{1}{LiCi}}$ et donc $C_i$ doit être proportionnel à l'inverse de la fréquence centrale, ainsi que $L_i$, qui est la valeur d'inductance équivalente au point $31_B$.

L'exemple chiffré qui suit est donné afin d'illustrer la façon de définir les caractéristiques des capacités, à titre d'exemple. Le résultat sera affiné par simulation selon des méthodes connues de l'homme du métier.

Le nombre de capacités commutées est déterminé en première approximation par df/f = résolution du filtre (à la fréquence la plus élevée) = $1 / 2^N$, où N est le nombre de capacités en première approximation étagées de deux en deux en valeurs. Par exemple, si à 500 MHz un pas de 0.5 MHz est recherché, il faut au moins 1024 valeurs de capacités soit 10 bit / 10 valeurs distinctes de capacités étagées de deux en deux.

Selon une première variante de réalisation, un point d'accès pour une capacité peut être disposé tous les demi-tours de l'inductance lorsque cette dernière se présente sous la forme d'une bobine.

Les explications qui ont été données s'appliquent dans des filtres comprenant une ligne de transmission « courte » devant la longueur d'onde $\lambda/4$, la ligne pouvant être modélisée par une self pour les basses fréquences.

Le filtre accordable selon la présente invention offre notamment les avantages suivants :

- Une réponse à bande constante naturelle sans approximation,
- Une constante de la réponse du filtre, bande passante et réjection, avec la fréquence d'accord,
- Une possibilité d'optimiser le filtre, sans compromis, sur de larges bandes d'accord.
  Les valeurs de capacité et leur position spatiale choisies permettent notamment :

- De couvrir des bandes d'accord importantes $\dfrac{1}{2\pi\sqrt{\dfrac{1}{L_{equi}*C_{equi}}}}$ pouvant être supérieures à l'octave pour un filtre de puissance (ayant des éléments parasites importants),
- De maintenir une impédance de résonateur constante dans toute la plage d'accord,

- Ce qui permet, avec un couplage inductif simple entre les résonateurs, d'obtenir un filtre à bande quasi constante dans une large bande d'accord.


**Revendications**

**1.** Filtre accordable comportant au moins deux résonateurs accordables (30, 40), un premier résonateur des au moins deux résonateurs accordables comprenant au moins une inductance ou ligne de transmission (31), ladite inductance ou ligne de transmission ayant une première extrémité ($31_A$) connectée à la masse M et une deuxième extrémité ($31_B$) couplée à un deuxième résonateur des au moins deux résonateurs accordables via une impédance de couplage (32), et plusieurs capacités commutées (33i) comportant plusieurs capacités de valeurs qui varient en fonction de la position sur la longueur de l'inductance ou ligne de transmission dont:

• Ladite inductance ou ligne de transmission (31) comporte plusieurs points d'accès (31i) ou points de connexion distribués le long de ladite inductance ou ligne de transmission (31) permettant de connecter ou non une capacité commutée (33i) dont la valeur est définie en fonction de sa position sur l'inductance ou ligne de transmission,
• Les capacités commutées sont réparties le long de l'inductance ou ligne de transmission de la manière suivante : les capacités de poids forts, correspondant aux basses fréquences d'accord, donc à une valeur élevée d'inductance équivalente vue à la deuxième extrémité ($31_B$) de ladite inductance ou ligne de transmission, sont disposées plus loin de la masse que les capacités de poids faibles, correspondant aux hautes fréquences qui sont disposées près de la masse vers la première extrémité ($31_A$) de l'inductance ou ligne de transmission,
• Les valeurs des capacités et leurs positions sur l'inductance ou ligne de transmission sont définies de façon à ce que l'impédance du résonateur soit maintenue constante dans toute la bande d'accord du filtre accordable, et l'impédance du résonateur $\sqrt{\dfrac{L_{equi}}{C_{equi}}}$ est maintenue constante à la fréquence de résonance accordable

$\dfrac{1}{2\pi\sqrt{\dfrac{1}{L_{equi}*C_{equi}}}}$ ,

$L_{equi}$ étant la valeur de l'inductance équivalente vue à la deuxième extrémité (31B) de ladite inductance ou ligne de transmission, $C_{equi}$ étant la capacité correspondant à l'ensemble des capacités commutées, pour une configuration donnée du résonateur.

**2.** Filtre accordable selon la revendication 1 **caractérisé en ce que** le nombre N de capacités et la ou les capacités à activer sont fixés en fonction du pas de variation δf de fréquence et de la plage de fonctionnement [$F_{min}$,$F_{max}$].

**3.** Filtre accordable selon l'une des revendications précédentes **caractérisé en ce qu'**il comporte une diode PIN (34) reliée à une capacité commutée, ladite diode étant adaptée à commuter ladite capacité commutée sur réception d'une commande de commutation (35).

**4.** Filtre accordable selon l'une des revendications précédentes **caractérisé en ce que** la position des points d'accès et les valeurs de capacité commutées sont choisies afin d'obtenir pour le filtre une valeur d'impédance interne à la fréquence centrale $F_C$ vue par le filtre à la deuxième extrémité ($31_B$) de ladite inductance proche de l'impédance de couplage (32) quasi constante.

**5.** Filtre accordable selon l'une des revendications précédentes **caractérisé en ce que** la bande de fréquence de fonctionnement est la bande Très Haute Fréquence VHF.

**6.** Filtre accordable selon l'une des revendications précédentes **caractérisé en ce que** la bande de fréquence de fonctionnement est la bande Ultra Haute Fréquence UHF.

**7.** Emetteur/récepteur radio **caractérisé en ce qu'**il comporte un ou plusieurs filtres accordables selon l'une des revendications précédentes.

**8.** Procédé de mis en œuvre d'un filtre accordable selon l'une des revendications 1 à 6, le filtre fonctionnant dans une plage de fréquence [$F_{min}$, $F_{max}$] avec une fréquence d'accord $F_{accord}$, le procédé comprenant les étapes suivantes :

• On choisit le nombre N de capacités, leur position en fonction de la plage de fréquence et du pas de fréquence,
• On choisit le nombre de capacités à commuter afin d'obtenir une largeur de bande passante constante et une bande de réjection constante avec la fréquence d'accord.

## Patentansprüche

**1.** Abstimmbares Filter das mindestens zwei abstimmbare Resonatoren (30, 40) aufweist, wobei ein erster Resonator der mindestens zwei abstimmbaren Resonatoren mindestens eine Induktivität oder Übertragungsleitung (31) umfasst, wobei die Induktivität oder Übertragungsleitung ein mit der Masse M verbundenes erstes Ende ($31_A$) und ein über eine Kopplungsimpedanz (32) mit einem zweiten Resonator der mindestens zwei abstimmbaren Resonatoren gekoppeltes zweites Ende ($31_B$) und mehrere geschaltete Kapazitäten (33i) aufweist, die mehrere Kapazitäten mit Werten umfassen, die je nach der Position auf der Länge der Induktivität oder Übertragungsleitung variieren, wobei:

• die Induktivität oder Übertragungsleitung (31) mehrere Zugangspunkte (31i) oder Verbindungspunkte hat, die entlang der Induktivität oder Übertragungsleitung (31) verteilt sind und das Verbinden oder Nichtverbinden einer geschalteten Kapazität (33i) zulassen, deren Wert je nach ihrer Position auf der Induktivität oder Übertragungsleitung definiert ist,
• die geschalteten Kapazitäten wie folgt entlang der Induktivität oder Übertragungsleitung verteilt sind: die hochgewichtigen Kapazitäten entsprechend den niedrigen Abstimmfrequenzen und somit einem hohen äquivalenten Induktivitätswert, am zweiten Ende ($31_B$) der Induktivität oder Übertragungsleitung gesehen, sind weiter von der Masse entfernt angeordnet als die niedergewichtigen Kapazitäten entsprechend den hohen Frequenzen, die in der Nähe der Masse zum ersten Ende ($31_A$) der Induktanz oder Übertragungsleitung hin angeordnet sind,
• die Werte der Kapazitäten und ihre Positionen auf der Induktivität oder Übertragungsleitung so definiert sind, dass die Impedanz des Resonators im gesamten Abstimmbereich des abstimmbaren Filters konstant gehalten wird und die Impedanz des Resonators $\sqrt{\dfrac{L_{\text{äqui}}}{C_{\text{äqui}}}}$ auf der abstimmbaren Resonanzfrequenz $\dfrac{1}{2\pi\sqrt{\dfrac{1}{L_{\text{äqui}}*C_{\text{äqui}}}}}$ konstant gehalten wird, wobei $L_{\text{äqui}}$ der äquivalente Induktivitätswert am zweiten Ende (31B) der Induktivität oder Übertragungsleitung gesehen ist, wobei $C_{\text{äqui}}$ die Kapazität entsprechend sämtlichen geschalteten Kapazitäten für eine gegebene Konfiguration des Resonators ist.

2. Abstimmbares Filter nach Anspruch 1, **dadurch gekennzeichnet, dass** die Anzahl N von Kapazitäten und die ein oder mehreren zu aktivierenden Kapazitäten in Abhängigkeit vom Frequenzänderungsschritt $\delta f$ und vom Betriebsbereich [$F_{min}$, $F_{max}$] festgelegt sind.

3. Abstimmbares Filter nach einem der vorherigen Ansprüche, **dadurch gekennzeichnet, dass** es eine PIN-Diode (34) umfasst, die mit einer geschalteten Kapazität verbunden ist, wobei die Diode zum Schalten der geschalteten Kapazität bei Empfang eines Schaltbefehls (35) ausgelegt ist.

4. Abstimmbares Filter nach einem der vorherigen Ansprüche, **dadurch gekennzeichnet, dass** die Position der Zugangspunkte und die Werte von geschalteten Kapazitäten so gewählt werden, dass für das Filter ein Innenimpedanzwert bei der Mittenfrequenz $F_c$ erhalten wird, gesehen vom Filter am zweiten Ende ($31_B$) der Induktivität in der Nähe der quasi-konstanten Kopplungsimpedanz (32).

5. Abstimmbares Filter nach einem der vorherigen Ansprüche, **dadurch gekennzeichnet, dass** das Betriebsfrequenzband das VHF-(Very High Frequency)-Band ist.

6. Abstimmbares Filter nach einem der vorherigen Ansprüche, **dadurch gekennzeichnet, dass** das Betriebsfrequenzband das UHF-(Ultra High Frequency)-Band ist.

7. Funksender/-empfänger, **dadurch gekennzeichnet, dass** er ein oder mehrere abstimmbare Filter nach einem der vorherigen Ansprüche umfasst.

8. Verfahren zur Verwendung eines abstimmbaren Filters nach einem der Ansprüche 1 bis 6, wobei das Filter in einem Frequenzbereich [$F_{min}$, $F_{max}$] mit einer Abstimmfrequenz $F_{Abstimm}$ arbeitet, wobei das Verfahren die folgenden Schritte beinhaltet:

   • Auswählen der Anzahl N von Kapazitäten und ihrer Position in Abhängigkeit vom Frequenzbereich und vom Frequenzschritt,
   • Auswählen der Anzahl von zu schaltenden Kapazitäten, so dass eine konstante Bandbreite und ein konstantes Sperrband mit der Abstimmfrequenz erreicht wird.

**Claims**

1. A tunable filter having at least two tunable resonators (30, 40), a first resonator of the at least two tunable resonators comprising at least one inductance or transmission line (31), said inductance or transmission line having a first end ($31_A$) connected to the ground M and a second end ($31_B$) coupled to a second resonator of the at least two tunable resonators via a coupling impedance (32), and several switched capacitors (33i) having several value capacitators that vary depending on the position on the length of the inductance or the transmission line of which

   • said inductance or transmission line (31) has several access points (31i) or connection points distributed along said inductance or transmission line (31) allowing to connect or not connect a switched capacitor (33i) whose value is defined as a function of its position on the inductance or transmission line,
   • the switched capacitators are distributed along the inductance or transmission line in the following way: the capacitators of high weight, corresponding to the low tune frequencies, hence to an equally high inductance value seen at the second end ($31_B$) of said inductance or transmission line, are disposed further away from the ground than the capacitators of low weights, corresponding to the high frequencies that are disposed close to the ground towards the first end ($31_A$) of the inductance or the transmission line,
   • the values of the capacitors and their positions on the inductance or the transmission line are defined so that the impedance of the resonator is kept constant throughout the tuning band of the tunable filter, and the impedance of the resonator $\sqrt{\dfrac{L_{equi}}{C_{equi}}}$ is kept constant at the tunable resonance frequency $\dfrac{1}{2\pi\sqrt{\dfrac{1}{L_{equi}*C_{equi}}}}$ $L_{equi}$ being the value of the equivalent inductance seen at the second end (31B) of said inductance or transmission line, $C_{equi}$ being the capacitator corresponding to all the switched capacitators, for a given configuration of the resonator.

**2.** The tunable filter according to claim 1, **characterized in that** the number N of capacitors and the capacitor or capacitors to be activated is/are fixed as a function of the frequency variation pitch $\delta f$ and of the operating range $[F_{min}, F_{max}]$.

**3.** The tunable filter according to one of the preceding claims, **characterized in that** it comprises a PIN diode (34) linked to a switched capacitor, said diode being adapted to switch said switched capacitor on reception of a switching command (35).

**4.** The tunable filter according to one of the preceding claims, **characterized in that** the position of the access points and the switched capacitors values are chosen in order to obtain for the filter an internal impedance value at the central frequency $F_c$ seen by the filter at the second end ($31_B$) of said inductance close to the coupling impedance (32) that is quasi-constant.

**5.** The tunable filter according to one of the preceding claims, **characterized in that** the operating frequency band is the Very High Frequency VHF band.

**6.** The tunable filter according to one of the preceding claims, **characterized in that** the operating frequency band is the Ultra High Frequency UHF band.

**7.** A radio transceiver, **characterized in that** it comprises one or more tunable filters according to one of the preceding claims.

**8.** A method for implementing a tunable filter according to one of claims 1 to 6, the filter operating in a frequency range $[F_{min}, F_{max}]$ with a tuning frequency $F_{tuning}$, the method comprising the following steps of:

  • choosing the number N of capacitors, their position as a function of the frequency range and of the frequency pitch,
  • choosing a number of capacitors to be switched in order to obtain a constant pass bandwidth and a constant rejection band with the tuning frequency.

Adaptation

Couplage

Adaptation

*Impédance interne*

*Impédance de couplage*

*Impédance interne*

FIG.1

FIG.2

FIG.3

EP 3 549 260 B1

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2006087388 A
- JP S6033724 B

- US 2004036551 A